# EUROPÄISCHE PATENTANMELDUNG

(11) **EP 0 898 303 A2**
(43) Veröffentlichungstag der Anmeldung: **24.02.1999**
(21) Anmeldenummer: 98115855.3
(22) Anmeldetag: 21.08.1998
(51) Int. Cl.: H01L 21/314, C23C 16/36, C23C 16/30, H01B 3/12, C04B 41/50, C03C 17/22, C01B 21/087, C01B 21/082, C01B 31/30

(54) **Elektrisch isolierendes Dünnschichtsystem mit definierter elektrischer Restleitfähigkeit**

(30) Priorität: 22.08.1997 DE 19736664; 12.09.1997 DE 19740189
(71) Anmelder: FRAUNHOFER-GESELLSCHAFT ZUR FÖRDERUNG DER ANGEWANDTEN FORSCHUNG E.V., 80636 München (DE)
(72) Erfinder: Weber, Andreas, Dr., 38104 Braunschweig (DE); Höing, Thomas, 38106 Braunschweig (DE)
(74) Vertreter: Einsel, Martin, Dipl.-Phys.

(57) **Zusammenfassung**

Die vorliegende Erfindung betrifft ein elektrisch isolierendes Dünnschichtsystem der allgemeinen Zusammensetzung GeₖSiₗCₓE_{y}H_{z} mit definiert einstellbarer Restleitfähigkeit, wobei E für mindestens ein Element der V. Hauptgruppe steht und k+l, x, z und y jeweils > 0 sind.

## Beschreibung

Die vorliegende Erfindung betrifft ein elektrisch isolierendes Dünnschichtsystem mit definierter elektrischer Restleitfähigkeit sowie ein Verfahren zur dessen Herstellung.

Für zahlreiche Anwendungen in der Elektrotechnik und Elektronik werden elektrische Potentiale zwischen elektrisch leitenden und isolierenden Materialien erzeugt. Dies ist z. B. der Fall bei elektronischen Hochleistungsbauelementen, Detektorsystemen in der Hochenergiephysik und in Trockenkopier- und Druckersystemen.

Ein wesentliches Problem bei derartigen Bauteilen besteht darin, daß auf der Isolatorfläche elektrische Ladungen akkumuliert werden, die beispielsweise zu einer Verzerrung des elektrischen Feldes, zum Aufbau von Gegenspannungen und bei offenen Systemen zur unerwünschten elektrostatischen Anziehung von Partikeln und als Folge davon zum Versagen des Bauteils führen können.

Zur Vermeidung der Akkumulierung von elektrischer Ladung wurde die Verwendung von isolierenden Dünnschichtsystemen mit einer gewissen Restleitfähigkeit vorgeschlagen.

So ist bekannt, daß der spezifische Widerstand von Ge-C : H und Si-C : H Schichten in Abhängigkeit von der Stöchiometrie Werte von 10⁴ bis 10⁸ Ohm.cm (J. Bullot, M. P. Schmidt in "Physics of Amorphous Silicon-Carbon Alloys" Review Article, Phys. Stat. Sol. 143, 345 (1997) bzw. 10⁵ bis 10¹³ Ohm.cm (Gmelin "Amorphous Si-C Alloys" Handbook Si Suppl. Vol. B2 und M. Gazicki, K. Pirker, R. Schallauer, W. Fallmann, F. Olcaytug, G. Urban, A. Jachimowicz, F. Kohl in " Deposition and Properties of Germanium-Carbon Alloy Films Produced from Tetramethylgermanium in an R. F. Discharge" Thin Solid Films, 187 (1990) 51-63) haben kann.

Schichten für die vorstehend genannten Anwendungen müssen jedoch gleichzeitig hinreichend stabil sein, d.h. die Eigenschaften der Schichten dürfen sich unter Anwendungsbedingungen, wie Temperaturbelastung, Strahlenbelastung und Beschuß mit energetischen Teilchen, nicht ändern.

Beispielsweise zeigen im System Si-C:H lediglich Schichten mit C/Si = 1,5 bis 4 at% und H ≤ 30 at% eine ausreichende Stabilität. Hierbei ist jedoch der erzielbare Widerstandsbereich sehr eingeschränkt. So ergaben Messungen der Anmelderin an mittels Plasmapolymerisation hergestellten stabilen Ge-C : H und Si-C : H Schichten spezifische Widerstände, die nur in einem vergleichsweise engen Bereich von 10⁴ bis 10⁷ Ohm.cm variierbar waren.

Es ist daher Aufgabe der vorliegenden Erfindung, ein elektrisch isolierendes Dünnschichtsystem mit definierter elektrischer Restleitfähigkeit zur Verfügung zu stellen, dessen spezifischer Widerstand über einen weiten Bereich auf einfache Weise einstellbar ist und das gleichzeitig eine hohe Stabilität aufweist.

Diese Aufgabe wird gelöst durch ein Dünnschichtsystem mit der allgemeinen Zusammensetzung GeₖSiₗCₓE_{y}H_{z}, wobei E für mindestens ein Element der V. Hauptgruppe steht und k + l, x, z und y jeweils > 0 sind.

Weiter betrifft die vorliegende Erfindung ein Verfahren zur Herstellung des Dünnschichtsystems.

Durch einfache Variation des Gehalts an Element der V. Hauptgruppe kann der spezifische Widerstand des Dünnschichtsystems in einem weiten Bereich von 10⁴ bis 10¹² Ohm.cm kontrolliert eingestellt werden.

Gemäß einer bevorzugten Ausführungsform wird das Dünnschichtsystem einer Temperbehandlung unterzogen, wodurch der spezifische Widerstand zusätzlich um einen Faktor 10 bis 100 erhöht werden kann.

Folglich läßt sich der spezifische Widerstand des erfindungsgemäßen Dünnschichtsystems in einem Bereich von 10⁴ bis 10¹⁴ Ohm.cm gezielt einstellen.

Mit dem erfindungsgemäßen Dünnschichtsystem kann einerseits die notwendige isolierende Wirkung eines dielektrischen Substrats aufrechterhalten werden. Andererseits verhindert das System aufgrund seiner intrinsischen Restleitfähigkeit eine unerwünschte Ansammlung von elektrischer Ladung an der Oberfläche.

Darüberhinaus weist das erfindungsgemäße System ausgezeichnete Stabilität wie z.B. Temperaturbeständigkeit, insbesondere in bezug auf den spezifischen Widerstand, auf.

Mit der vorliegenden Erfindung werden somit erstmals temperaturbeständige Beschichtungen mit definierten stabilen Oberflächenleitfähigkeiten auf der Basis der vorstehendgenannten bekannten Schichtsysteme zur Verfügung gestellt.

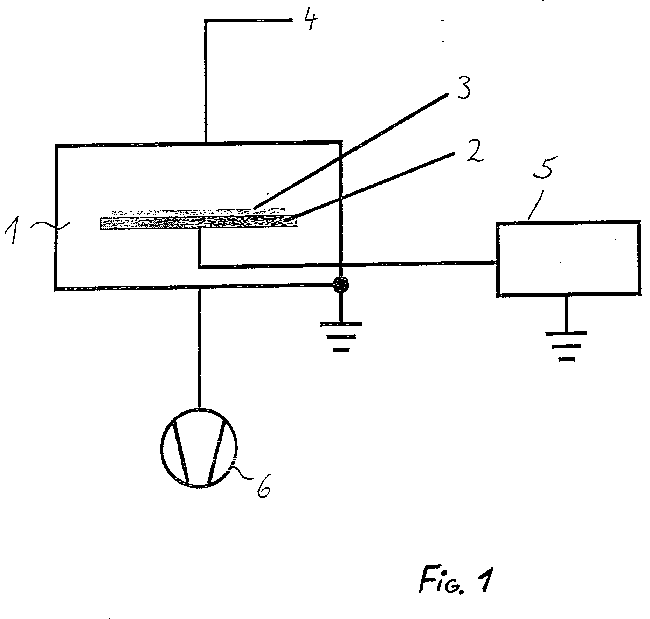

Figur 1 zeigt die Vorrichtung zur Abscheidung eines Dünnschichtsystems, das für Beispiel 1 eingesetzt worden ist.

Bei dem erfindungsgemäßen Dünnschichtsystem kann es sich um eine beliebige GeCEH, SiCEH oder GeSiCEH Schicht handeln, wobei E für eine Element der V. Hauptgruppe steht. Wesentlich ist das Vorhandensein eines Elements der V. Hauptgruppe, wie Stickstoff, Phosphor, Arsen, Antimon oder Wismut, wobei Stickstoff besonders bevorzugt ist. Es können auch mehr als nur ein Element der V. Hauptgruppe eingesetzt werden.

Im folgenden beziehen sich die Gehaltsangaben jeweils auf die Gesamtzusammensetzung des Dünnschichtsystems.

Der Gehalt an Element bzw. Elementen der V. Hauptgruppe beträgt vorzugsweise 1 bis 30 at%, insbesondere 2 bis 20 at% und besonders bevorzugt 6 bis 15 at%.

Oberhalb 30 at% ändert sich der Widerstand nur noch wenig und unterhalb 1 at% kann eine Verringerung der Alterungsbeständigkeit und damit der Stabilität auftreten.

Beispielsweise können Si-CE : H Schichten mit einem Gehalt an E, vorzugsweise mit E = N, in einem Bereich von 6 bis 15 at% vorteilhaft für Sensoranwendungen eingesetzt werden.

Der Gehalt der anderen Komponenten im Systems kann in einem weiten Bereich variieren, solange die erforderliche Menge an Element bzw. Elementen der V. Hauptgruppe vorhanden ist und der Gehaltsanteil der jeweiligen Komponente mit Ausnahme von Germanium oder Silicium größer als Null ist.

Bevorzugte Gehaltsbereiche für die einzelnen Komponenten sind wie folgt:
Ge + Si = 5 bis 40 at% mit Ge/Si = 0 bis 1;
C = 30 bis 85 at%;
H = 5 bis 30 at%.

Dabei können in dem erfindungsgemäßen Dünnschichtsystem diese Komponenten jeweils für sich oder auch gleichzeitig in den vorstehend genannten Gehaltsbereichen vorliegen.

Beispielsweise verhindert die Anwesenheit von Wasserstoff oder Kohlenstoff, daß das System spröde wird.

Die Dicke des Dünnschichtsystems liegt im allgemeinen in einem Bereich von 10 bis 5000 nm, vorzugsweise von 100 bis 180 nm. Bei Bedarf kann die Dicke selbstverständlich auch größer oder kleiner gewählt werden.

Üblicherweise liegt die erfindungsgemäße Dünnschicht in amorpher Form vor oder es bilden sich sogenannte Nanokristallite in einer amorphen Matrix aus.

Unter dem Begriff 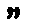 Nanokristallite" werden kleine Kristalle verstanden, die im allgemeinen einen Durchmesser < 100 nm haben. Als Beispiel können SiN-SiC-Mischkristalle genannt werden.

Die erfindungsgemäße Dünnschicht kann auf einem beliebigen Substratmaterial abgeschieden werden. Beispiele hierfür sind Glas, Kunststoff wie Polycarbonat, Metall oder ein Halbleitermaterial.

Überraschenderweise hat sich gezeigt, daß der spezifische Widerstand der erfindungsgemäßen Schicht durch Tempem um einen Faktor 10 bis 100 zusätzlich erhöht werden kann. Das Tempem kann an Luft erfolgen, ohne daß Sauerstoff in das Schichtsystem eingebaut wird. Die Temperatur kann bei 250 °C und darunter, vorzugsweise im Bereich von 80° C bis 250° C und insbesondere von 80° C bis 150° C, liegen. Falls erforderlich, kann eine höhere oder auch niedrigere Temperatur gewählt werden.

Das erfindungsgemäße Dünnschichtsystem läßt sich mit einem üblichen plasmagestützten Abscheidungsverfahren erhalten. Als Beispiel sei die Plasmapolymerisation genannt. Bei dem Plasma kann es sich um ein Niederfrequenzplasma, ein Hochfrequenzplasma oder ein Mikrowellenplasma handeln.

Vorzugsweise erfolgt die Abscheidung bei niedrigen Temperaturen, insbesondere bei einer Temperatur < 150° C.

Soweit die Komponenten nicht per se gasförmig vorliegen, werden flüchtige, vorzugsweise organische Ausgangsverbindungen eingesetzt, wie sie für plasmagestützte Abscheidungsverfahren allgemein gebräuchlich sind.

Beispiele dafür sind gasförmige bzw. leichtflüchtige Silicium- oder Germaniumverbindungen wie Tetramethylsilane oder Tetramethylgerman. Beispiele für bevorzugt eingesetzte flüchtige Verbindungen von Elementen der V. Hauptgruppe sind die entsprechenden Wasserstoffverbindungen, z. B. EH 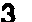 oder organische Verbindungen, z. B. E(CH 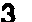 ) 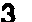 wie P(CH 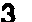 ) 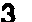 .

Im folgenden wird die Erfindung anhand von Beispielen veranschaulicht.

### Beispiel 1

In einem Parallelplattenreaktor (1) wurde bei einem Arbeitsdruck von 1 Pa in einer Gasatmosphäre von 20 Vol.% Ar, 60 Vol.% N₂ und 20 Vol.% Tetramethylsilan ein Hochfrequenzplasma (13,6 MHz) aufrechterhalten. Bei einer Leistung von 150 W stellte sich eine Selfbias-Spannung von minus 400 V an der Substratelektrode (2) ein. Auf der zu beschichtenden Probe (3), einer 300 x 300 mm² große Glasplatte, die auf der Substratelektrode (2) lag, scheidete sich innerhalb von 10 min. eine 100 nm dicke a-SiCN:H Schicht mit einem spezifischen Widerstand von 5x10⁸ Ohm.cm ab, entsprechend einem Oberflächenwiderstand von 5x10¹³ Ohm/square.
Nach der Entnahme aus dem Rezipienten wurde die Platte bei 150° C an Luft 60 min getempert. Die Messung des Oberflächenwiderstandes ergab 10¹⁵ Ohm/square (ein Faktor 100 weniger als der Oberflächenwiderstand der unbeschichteten Glasoberfläche). Der spezifische Widerstand der Schicht betrug somit 1x10¹⁰ Ohm.cm.
Die hier verwendete Vorrichtung ist in Figur 1 gezeigt.
Die Elementaranalyse ergab Si 14 at%, C 53 at%, N 14 at% und H 19 at%.

### Beispiel 2

In einem Plasmareaktor wurde in einer Gasatmosphäre von 70 Vol.% Ar, 10 Vol.% N₂ und 20 Vol.% Tetramethylgerman bei einem Arbeitsdruck von 2 Pa ein 200 Watt Mikrowellenplasma eingekoppelt. An der Substratelektrode wurde mit einem 100 kHz Niederfrequenzgenerator zusätzlich eine Biasspannung von minus 80 V angelegt. Auf einer Polycarbonatscheibe mit einem Durchmesser von 100 mm wurden innerhalb von 10 min. eine 180 nm dicke a-GeCN:H Schicht abgeschieden, die einen Oberflächenwiderstand von 5 x 10 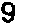 Ohm/square hatte.
Nach 3 Stunden Tempem an Luft bei 80° C wurde ein Oberflächenwiderstand von 3x10¹⁰ Ohm/square erhalten. Der spezifische Widerstand der Schicht betrug somit 5x10⁵ Ohm.cm. Die Elementaranalyse ergab Ge 18 at%, C 62 at%, N 5 at% und H 15 at%.

### Bezugszeichenliste

- (1): Parallelplattenreaktor
- (2): Substratelektrode
- (3): Substrat
- (4): Prozeßgaszufuhr (Ar, N₂, Tetramethylsilan)
- (5): Generator
- (6): Vakuumpumpe

## Patentansprüche

1. Dünnschichtsystem mit der allgemeinen Zusammensetzung GeₖSiₗCₓE_{y}H_{z}, wobei E für mindestens ein Element der V. Hauptgruppe steht und k+l, x, z und y jeweils > sind.

2. Dünnschichtsystem nach Anspruch 1,
**dadurch gekennzeichnet,**
**daß** y einen Wert im Bereich von 1 bis 30 at% hat.

3. Dünnschichtsystem nach Anspruch 1 oder 2,
**dadurch gekennzeichnet,**
**daß** das System einen spezifischen Widerstand im Bereich von 10⁴ bis 10¹² Ohm.cm hat.

4. Dünnschichtsystem nach einem der vorhergehenden Ansprüche,
**dadurch gekennzeichnet,**
**daß** die Indizes, gleichzeitig oder unabhängig voneinander, k+l = 5 bis 40 at% mit Ge/Si = 0 bis 1, x =30 bis 85 at% und z = 5 bis 30 at%, bezogen auf die Gesamtzusammensetzung des Dünnschichtsystems, bedeuten.

5. Dünnschichtsystem nach einem der vorhergehenden Ansprüche,
**dadurch gekennzeichnet,**
**daß** y = 2 bis 20 at%.

6. Dünnschichtsystem nach einem der vorhergehenden Ansprüche,
**dadurch gekennzeichnet,**
**daß** E für Stickstoff steht.

7. Dünnschichtsystem nach einem der vorhergehenden Ansprüche,
**dadurch gekennzeichnet,**
**daß** das Schichtsystem amorph ist oder Nanokristallite in einer amorphen Matrix enthält.

8. Dünnschichtsystem nach einem der vorhergehenden Ansprüche,
**dadurch gekennzeichnet,**
**daß** das Dünnschichtsystem eine Dicke in einem Bereich von 10 bis 5000 nm hat.

9. Dünnschichtsystem nach Anspruch 7,
**dadurch gekennzeichnet,**
**daß** die Dicke in einem Bereich von 100 bis 180 nm liegt.

10. Dünnschichtsystem nach einem der vorhergehenden Ansprüche,
**dadurch gekennzeichnet,**
**daß** das Dünnschichtsystem einer Temperbehandlung unterzogen worden ist.

11. Dünnschichtsystem nach Anspruch 10, wobei der spezifische Widerstand des Systems einen Wert im Bereich von 10⁵ bis 10¹⁴ Ohm.cm hat.

12. Verfahren zur Herstellung eines Dünnschichtsystems nach einem der Ansprüche 1 bis 11,
**dadurch gekennzeichnet,**
**daß** das Dünnschichtsystem mittels plasmagestützter Abscheidung unter Verwendung gasförmiger oder leicht flüchtiger Ausgangsverbindungen auf einem Substrat erzeugt wird.

13. Verfahren nach einem der Ansprüche 11 oder 12,
**dadurch gekennzeichnet,**
**daß** als Substrat ein Glas-, Kunststoff-, Metall- oder Halbleitersubstrat ausgewählt wird.

14. Verfahren nach einem der Ansprüche 11 bis 13,
**dadurch gekennzeichnet,**
**daß** zur Abscheidung ein Niederfrequenz-, Hochfrequenz- oder Mikrowellenplasma eingesetzt wird.

15. Verfahren nach einem der Ansprüche 11 bis 14,
**dadurch gekennzeichnet,**
**daß** das Dünnschichtsystem nach der Abscheidung einer Temperbehandlung unterzogen wird.

16. Verfahren nach Anspruch 15,
**dadurch gekennzeichnet,**
**daß** die Temperbehandlung bei einer Temperatur von 250 °C oder weniger erfolgt.

17. Verfahren zur Einstellung des spezifischen Widerstandes eines Dünnschichtsystems nach einem der Ansprüche 1 bis 11, indem der Gehalt an Element der V. Hauptgruppe variiert wird.

18. Verfahren nach Anspruch 17,
**dadurch gekennzeichnet,**
daß der Gehalt an Element der V. Hauptgruppe in einem Bereich von 1 bis 30 at% varriiert wird.
